# EUROPEAN PATENT APPLICATION

(11) **EP 2 540 588 A1**
(43) Date of publication of application: **02.01.2013**
(21) Application number: 11005395.6
(22) Date of filing: 01.07.2011
(51) Int. Cl.: B60T 8/32, B60T 17/02, F15B 13/08, F15B 21/08, F16B 13/00, B60T 8/34, B60T 8/36, B60T 13/68, B60T 17/22

(54) **Module for a braking system, such as a coil box module comprising a housing and a connector**

(71) Applicant: Tyco Electronics Belgium EC BVBA, 8020 Oostkamp (BE)
(72) Inventor: Van Reybrouck, Koen, 3020 Oostkamp (BE); Desloovere, Peter, 8790 Waregem (BE); Vanwynsberghe, Koen, 8540 Deerlijk (BE); de Schepper, Tom, 9810 Nazareth (BE); Depoortere, Björn, 8750 Wingene (BE); Colpaert, Bart, 8820 Torhout (BE); van Cauwenberge, Jan, 9880 Aalter (BE)
(74) Representative: Grünecker, Kinkeldey, Stockmair & Schwanhäusser

(57) **Abstract**

The present invention relates to a braking system module (1), such as an coilbox (2), comprising a housing (3) and a connector (6). The connector comprises a connector body (7) and contact elements (8) defining a connection interface (9) for electrically connecting the braking module (1) with a plug connector. The present invention provide an braking module that is easy to produce and optimize in that the housing (3) comprises an anchorage organ (10) for mounting the connector (6) to the housing (3).

## Description

The present invention relates to a module for a braking system, for example an anti-lock braking system (ABS), such as a coil box comprising a housing and a connector. The connector comprises a connector body and contact elements defining a connector interface for electrically connecting the braking module with a plug-connector of a cable assembly.

Currently, the production of a braking module such as an electronic control unit designed as a coil box is complex and cumbersome because the different shapes of the connector interfaces and the number of contacts of the connector have a big influence on the mold flow and consequently the warpage in the complete mold of the braking module.

In view of these disadvantages of the known braking modules, an object underlying the present invention is to provide a braking module that is easy to produce and optimize, provides a high flexibility and versatility and reduces the required time to market.

The object is achieved by the above mentioned braking module in that the housing comprises an anchorage organ for mounting the connector to the housing.

This solution provides that a simple and optimized housing mold can be used because of the module design of the braking system of the present invention, the housing and the connector can be produced and optimized separately from each other. This provides a high flexibility because it is not necessary to design a new housing mould for each connector variant of a housing variant. Only one housing mold is needed per housing type, without having to take the different shapes of multiple connector interfaces and the number of connector contacts into account. This simplifies the mold. Metal Inlays in the housing mold can be omitted since no contacts need to be fed to the housing mold. Thus, the housing mold and the material flow thereof can be optimized independent from the connector type and the number of contacts. Likewise, the connector mold can be optimized independent from the housing mold, for example by selecting an optimized injection point location for the connector. Further, the connector contacts may be stitched, making an overmolding of the connector unnecessary. Since the same connector may be used on all module housing variants, and vice versa, the debugging period is shortened, which improves the time to market.

Furthermore, the inventive solution of producing the housing and the connector of a braking module independent from one another provides a modularity in which different connectors can be combined with different types of housings, so that there is no need to design a new, complex and expensive housing mold for each connector variant of one housing type.

The solutions according to the present invention can be combined as desired and further improved by the following embodiments that are in each case advantageous on their own.

According to a first embodiment of the braking module, the connector is mounted and optionally fixed at the anchorage organ of the housing. In this embodiment, the braking module is in the fully assembled state and ready to use, which is simply achieved by selecting the required housing type and the appropriate connector type and mounting the connector to the anchorage organ of the housing. Subsequently, the connector may be fixed at the anchorage organ of the housing. Several embodiments for mounting and fixing the connector to the anchorage organ of the housing are presented in the following.

In one embodiment, the anchorage organ may comprise a fitting that is adapted for coupling with a connection piece of the connector body. A connection piece is an element or part of the connector body that can be coupled with the fitting. The fitting may comprise an insertion opening for receiving the connection piece, or in another embodiment a coupling protrusion sticking out of the anchorage organ, such as for example a neck or a stub for engaging with the connection piece of the body. The connection piece of the connector and the fitting of the housing may be designed forming a positive or form-fit connection as well as a non-positive or frictional connection when mounting the connector to the anchorage organ of the housing.

For fixing the mounted connector body with the anchorage organ, the braking module may comprise a joining element for fixing the mounted connector with the anchorage organ. The joining element may be selected from the non-limiting list comprising at least one of a seam, a glue, and fastener, for example a bracket, clamp, screw or a snap fit.

The joining element may be arranged at the anchorage organ and/or at the connector body. In one embodiment, the connector may comprise a counter-latch forming a snap fit with the latch of the anchorage organ. The latch of the anchorage organ and the counter-latch of the connector body may be integrally designed with the anchorage organ and the connector body, respectively, in one piece by molding the latch and the counter-latch. Alternatively, a separate joining element may be used for fixing the mounted connector with the anchorage organ.

For avoiding that water or dirt may enter the junction between the anchorage organ and the connector body, the braking system may comprise a sealing element adapted to seal the junction between the anchorage organ and the connector body mounted thereto. In an embodiment of the braking module, the sealing element is placed at the junction between the anchorage organ and the connector body. The sealing element may also be a potting compound applied at the junction, which embodiment is well suited for embodiments of the braking module, where the joining element is a seam or glue, The seal may also be a gasket, washer, grommet or a simple O-ring. Each of the sealing elements may be adapted for bordering the fitting of the housing or the connection piece of the connector, either at the inside circumference or the outer circumference thereof, depending on whether the connection piece is received in the or encompasses the fitting of the housing. If the junction is between an abutting face of the connection piece of the connector and the fitting of the housing, the sealing element may be placed at the abutting face.

The invention will be described hereafter, in more detail and in an exemplary manner using advantageous embodiments and with reference to the drawings. The described embodiments are only possible configurations in which, wherever, the individual features as described above can be provided independent of one another and can be omitted in the drawings.
- Fig. 1: shows a schematic perspective view of a braking module from the prior art;
- Fig. 2: shows a schematic perspective view of the housing of a braking module according an embodiment of the present invention;
- Fig. 3: is a schematic perspective view of a connector of a braking module according to a first embodiment of the present invention;
- Fig. 4: is a schematic cross-sectional view of a braking module according to a first embodi-ment of the present invention comprising a housing of Fig. 2 and the mounted connec-tor of Fig. 3, shown at the cross-sectional line 4-4; and
- Fig. 5: is a schematic cross-sectional view of another embodiment of the braking module ac-cording to the present invention, shown at a cross-sectional line corresponding to the one of Fig. 4;
- Fig. 6: is a schematic perspective view of a housing of a braking module according to further embodiment of the present invention;
- Fig. 7: is a schematic perspective view of a connector for the housing shown in Fig. 6;
- Fig. 8: is a schematic perspective view of a braking module comprising the housing of Fig. 6 and the connector of Fig. 7; and
- Fig. 9: is a cross-sectional view of the braking module according to the embodiment shown in Fig, 8, shown at the cross-sectional line 9-9.

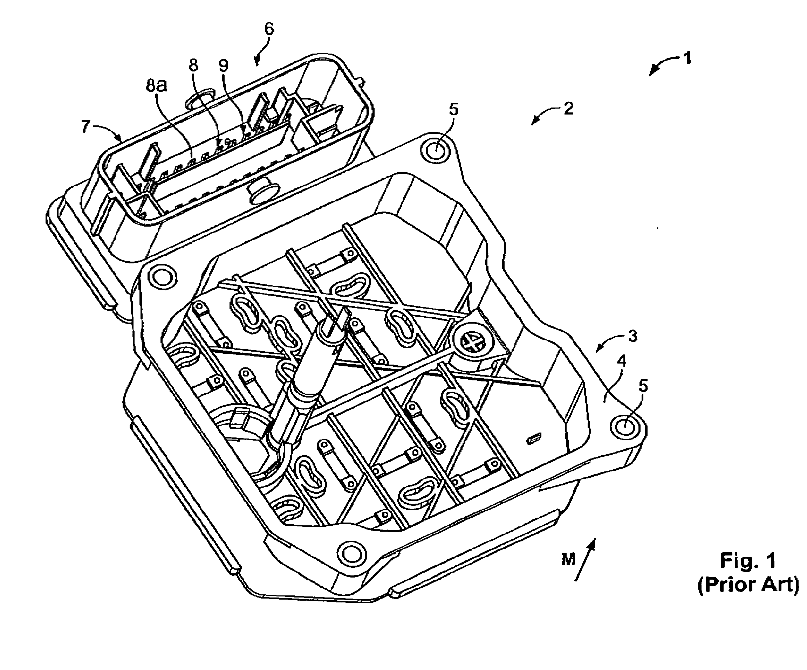

Fig. 1 shows a schematic perspective representation of a known braking module 1, namely a coil box module 2 of an electronic control unit of an anti-locking brake system (ABS).

The coil box 2 comprises a housing 3 for receiving the coils (not shown) that activate the valves in the hydraulic control unit (not shown) of the braking system (not shown). The coil box housing 3 is provided with a flange 4 for mounting the housing 3 with the hydraulic control unit, thus forming an electronic hydraulic control unit that is mounted in the vehicle. The flange 4 is provided at each of the four corners with bushing holes 5. When mounting the coil box 2 in a mounting direction M with the hydraulic control unit, attachment elements (not shown) are inserted in the mounting direction M through the bushing holes 5 for fastening the braking module 1 of the present invention with the hydraulic control unit of the braking system.

The braking module 1 further comprises a connector 6. The connector 6 comprises a connector body 7 and contact elements 8, here contact pins 8a, defining connector interfaces 9, 9a for electrically connecting the braking module 1. The connector interface 9 is facing in the mounting direction M and is designed for being connected with a counter-connector of the cable assembly after the electronic hydraulic control unit is mounted in the vehicle. The interface 9a is facing in the direction opposite the mounting direction M and is designed for the connection with a printed circuit-board (not shown) of the electronic control system.

The coil boxes 2 known from the prior art are designed as one integral piece in a molding process, which is complex and expensive because a very sophisticated housing mold is required for each connector-variant of one type of housing. Further the different shapes of the multiple connector-interfaces 9 and the number of connector contacts 8 thereof have a big influence on the mold flow and consequently the warpage in the complete braking module 1 mold.

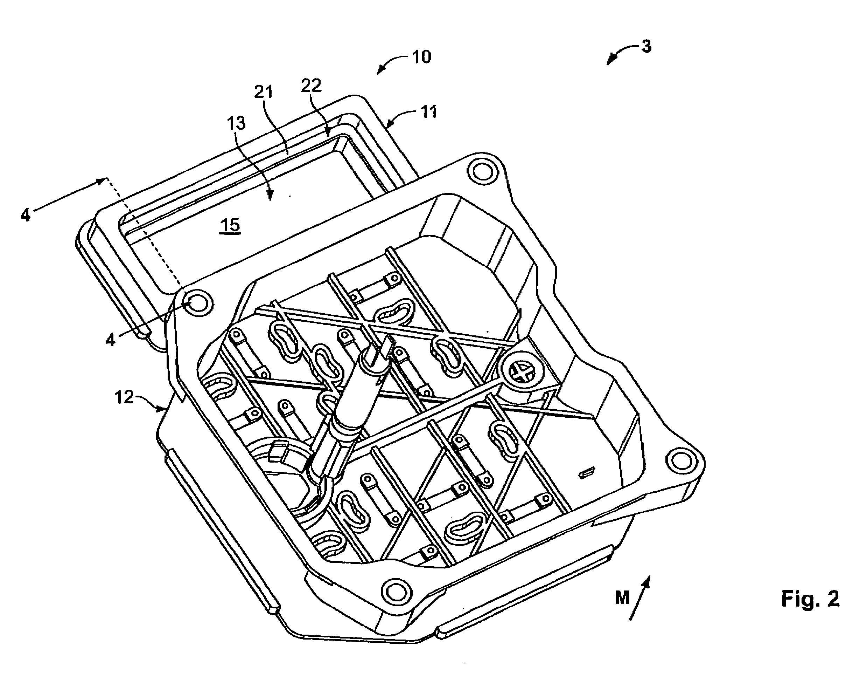

In the following, the advantages of the braking module 1 according to the present invention is described with reference to the embodiment shown in Figs. 2 to 9.

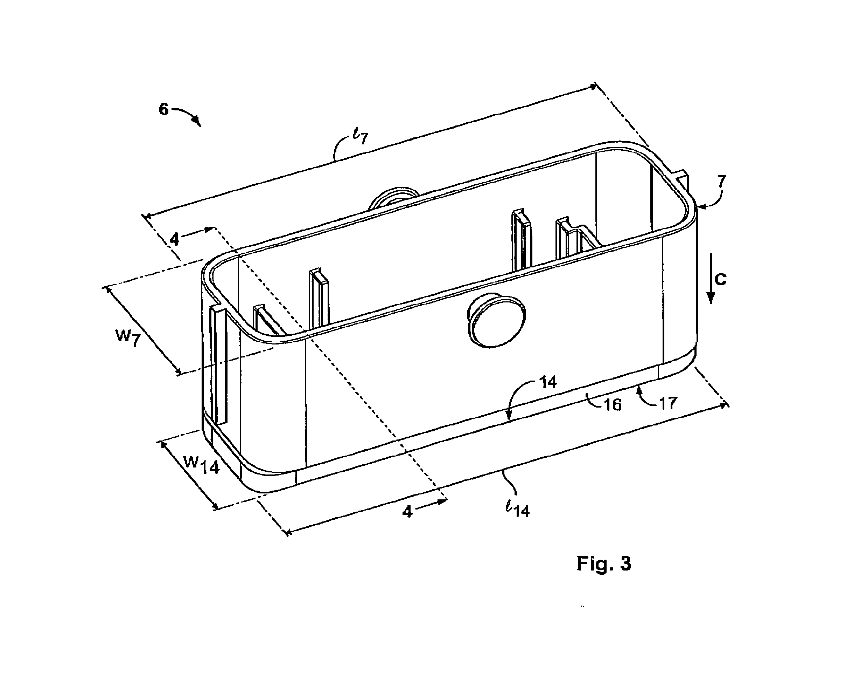

As shown in the schematic perspective views of Figs. 2 and 3, the braking module 1 of the present invention differs from the coil box 2 of the prior art by its modular design in that the housing 3 (Fig. 2) is produced separately from the connector 6 (Fig. 3).

The coil box housing 3 of the braking module 1 according to the present invention is principally designed similar to the coil box housing 3 of the braking module 1 known from the prior art.

Thus, in the following the same reference signs will be used for elements that structurally and/or functionally are similar or identical to elements of Fig. 1.

The braking module 1 according to the present invention comprises a housing 3 that is provided with an anchorage organ 10 for mounting the connector 6 to the housing. In the shown embodiment, the anchorage organ 10 is designed as an attachment frame 11 arranged at the outside of one of the sidewalls 12 of the coil box housing 3. In the shown embodiment, the side wall 12, where the attachment frame 11 is arranged, faces substantially perpendicular to the mounting direction M, in which the braking module 1 is mounted with the hydraulic control system. The anchorage organ 10 may of course be arranged at any position of the housing 3, provides that the connector 3 may be mounted on the anchorage organ 10.

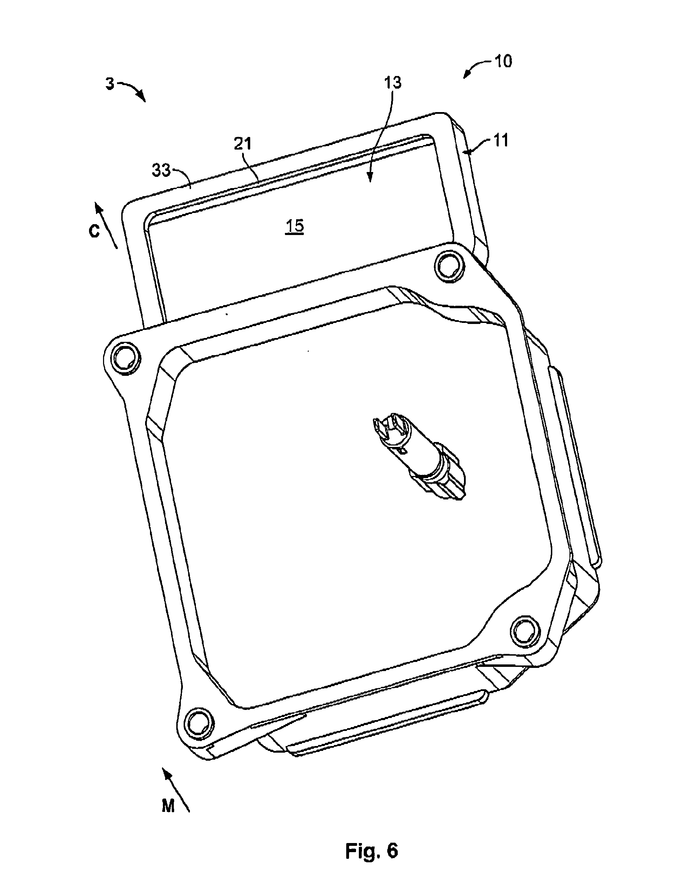

The attachment frame 11 comprises a fitting 13 for coupling a connection piece 14 of the connector body 7. The fitting 13 is designed, in the embodiment shown in Fig. 2, as an insertion opening 15, in which the connector body 7 of the connector 6 is received at least with its connection piece or part 14, when the connector 6 is coupled with the fitting 13. In the shown embodiment of Figs. 2 to 5, the connection piece 14 of the connector 6 is inserted in a coupling direction C, that is opposite to the mounting direction M in the insertion opening 15. Likewise, the connector 6 could be coupled/inserted in the mounting direction M with the fitting 13, as shown in the embodiment of Figs. 6 to 9.

In the embodiment of the connector 6 shown in Fig. 3, the connection piece 14 is designed by a groove 16 at the coupling face 17, directed in the coupling direction C at the bottom of the connector 6. In the exemplary design of the embodiment shown in Fig. 3, the width W₁₄ of the connection portion 14 is smaller than the width W₇ of the connector housing 7, and the length L₁₄ of the connector body 6 is shorter than the length L₇ of the remainder of the connector body 7.

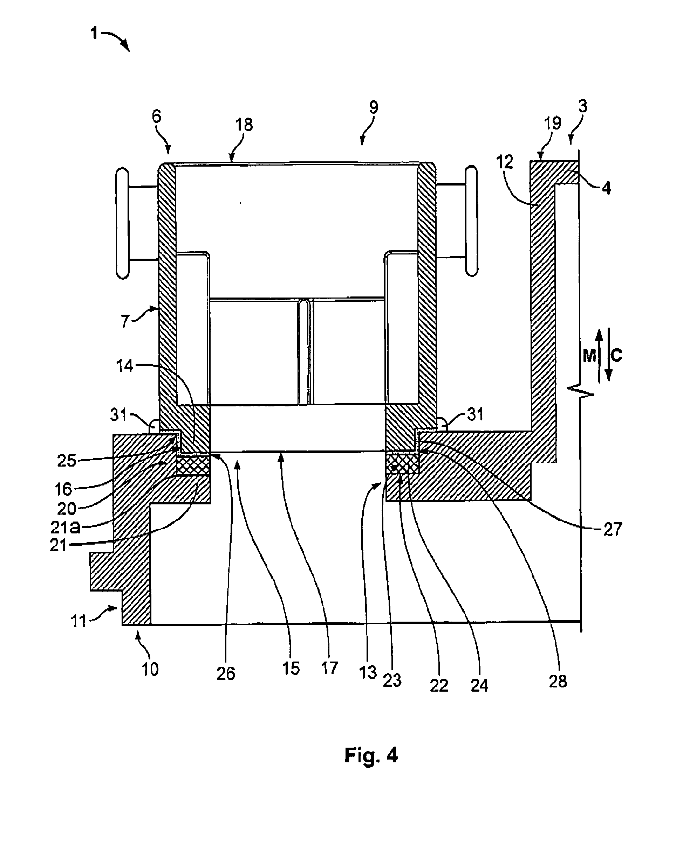

In Fig. 4, the braking module 1 of a first embodiment of the present invention, comprising the housing 3 of Fig. 2 and the connector 6 of Fig. 3 is shown in the fully assembled state in a cross-sectional view along the cross-section lines 4-4 in Figs. 2 and 3. For the sake of clarity, the contact pins 8a that constitute the contact elements 8 of the connector, are omitted in Fig. 4.

In the fully assembled state shown in Fig. 4, the connector 6 is mounted and fixed at the anchorage organ 10 of the housing 3. The connector body 7 is dimensioned such that, in the assembled state, the mounting face 18 of the connector body 7 facing in mounting direction M is arranged such that it is easily accessible and can be coupled with the corresponding contact connector of the cable assembly of the vehicle. In the shown embodiment, the mounting face 18 is substantially flush with the mounting face 19 of the flange 4 of the housing 3. In an alternative design, however, the mounting face 18 of the connector 6 can come lower or higher, in the mounting direction M, than the mounting face 19 of the housing 3 or can be arranged laterally with respect to the mounting direction M as long as the connector interface of the mounted electronic hydraulic control unit is freely accessible for coupling with the plug connector of the cable assembly.

The connection piece 14 of the connector body 7 is placed inside the insertion hole 15 of the fitting 13. In the shown embodiment of Fig. 4, the fitting area 20 of the attachment frame 11 encompassing the insertion hole 15 in the direction perpendicular to the mounting direction M is provided with a support lug 21, at its inside facing into the insertion hole 15. In the shown embodiment, the support lug 21 circumferences the insertion hole 15 completely and provide a step 21 a in the fitting portion area 20. The step 21 a forms a supporting surface 22 on which the connection piece 14 may rest in the assembled state,

In the embodiment shown in Fig. 4, a sealing element 23, designed as a gasket 24 is placed on the supporting surface 22 formed by the step 21 a and thus at the junction 28 between the anchorage organ 10 and the connector body 6 mounted thereto. The gasket 24 is sealing the junction 28 between the anchorage organ 10 and the connector body 7.

The groove 16 at the connection piece 14 of the connector body 7 is, in the assembled state, engaging with the shoulder 25 surrounding the insertion hole 15, thereby forming a positive fit between the connection piece 14 and the fitting 13 in the coupling direction C and in the direction perpendicular to the coupling direction C.

For fixing the connector body 6 with the attachment frame 11 of the anchorage organ 10, a joining element 26 is provided. In the shown embodiment, the joining element 26 is an adhesive glue 27 that is placed in and filling the junction 28 between the connection piece 14 of the connector body 7 and the fitting area 20 of the attachment frame 11, Instead of the glue 27, a seam 27 could be provided at the junction 28.

The braking module 1 of the present invention having a connector 6 and a housing 3 independently produced and then mounted and fixed together subsequently provides the advantage of a great versatility because only one mold for a type of housing 3 that is provided with an anchorage organ 10 for mounting a connector 6 is necessary. This housing can be combined with different connectors 6 so that it is not necessary to design a new housing mold if an common housing type 3 shall be produced with a different connector 6 having another connector interface 9, 9a.

Further, the housing mold is simplified because no care has to be taken on the specific design of the connector 6 which improves the mold flow in the housing mold. The same applies to the connector mold which can be optimized, for example with respect to the injection point, and the contact pins 8 can be integrally formed in the connector body 7.

The junction 28 may be made watertight in the embodiment shown in Fig. 4 by applying a potting compound 31 sealing junction 28 at the outside facing in the mounting direction M, thereof.

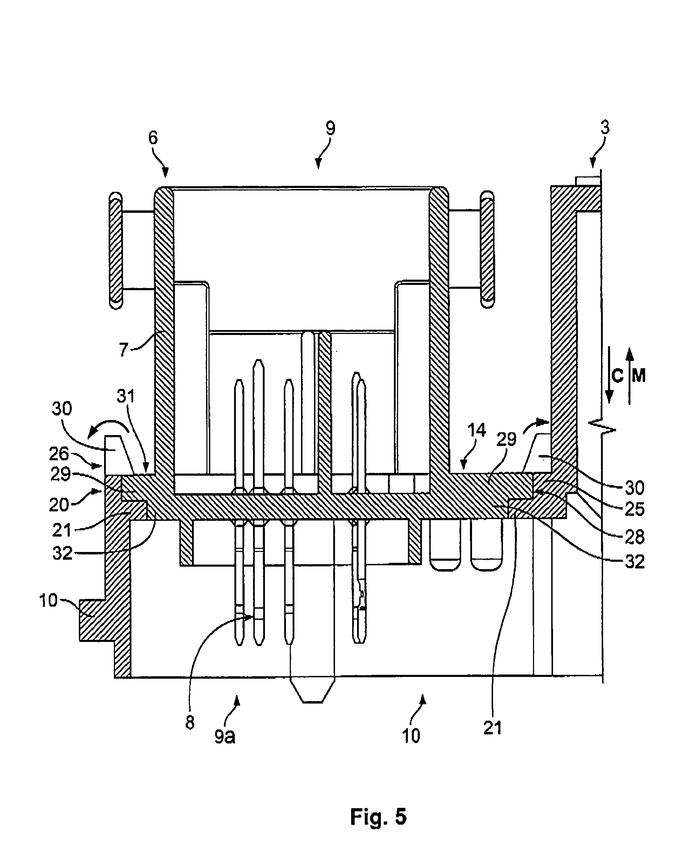

In Fig. 5, a second embodiment of the inventive braking module 1 is presented. In the following only the differences between the housing 3 and the connector 6 of the braking module 1 of the first embodiment, shown in Figs. 2 to 4, with respect to the housing 3 and the connector 6 of the braking module 1 of the second embodiment are explained.

The housing 3 of the second embodiment shown in Fig. 5 principally corresponds to the housing 3 of the first embodiment. The only difference is that the insertion opening 15 is wider in the second embodiment.

The connector 6 of the second embodiment principally corresponds to the connector 6 of the first embodiment, too. However, the connection piece 14 of the second embodiment is designed as a flange connection 29 protruding from the outer sidewalls of the connector body 7 in the second embodiment, instead of the groove 16 of the first embodiment.

The flange connection 29 is provided at its lateral sides with a pitch 32 that corresponds to and engages with the step 21a of the fitting area 20 of the attachment frame 11 when mounting the connector 6 with the anchorage organ 10 forming a similar positive fit as the one between the groove 16 and the shoulder 25 in the first embodiment.

In the second embodiment shown in Fig. 5, the connector 6 is fixed with the anchorage organ 10 by means of joining elements 26 designed as latches 30, which are integrally formed at the attachment frame 11. The latches 30 are provided at a coupling face 31 of the attachment frame 11 facing in the mounting direction M.

The latches 30 are deflected by the connection flange 29 of the connector body 7, when mounting the connector 6 in the coupling direction C with the anchorage organ 10, as indicated by the arrows in Fig. 5. After the connector 6 is correctly mounted with the anchorage organ 10, the latches 30 spring back into their resting position, as shown in Fig. 5, in which the connection flange 29 engages with the latch 30, thereby securing the connector 6 in the mounted position.

Thus, the latch 30 of the housing 3 and the connector flange 29 of the connector, forming a counter-latch element, can be engaged with each other such that the latch 30 abuts against a connection flange 29 and prevents the connector body 7 from being removed in the mounting direction M from the anchorage organ 10. This snap-fit 29, 30 allows for a simple and automatic mounting and simultaneous fixation of the connector 6 with the anchorage organ 10 of the housing 3 by inserting the connection piece 14 of the connector 6 in the coupling direction C into the insertion hole 15 of the anchorage organ 10.

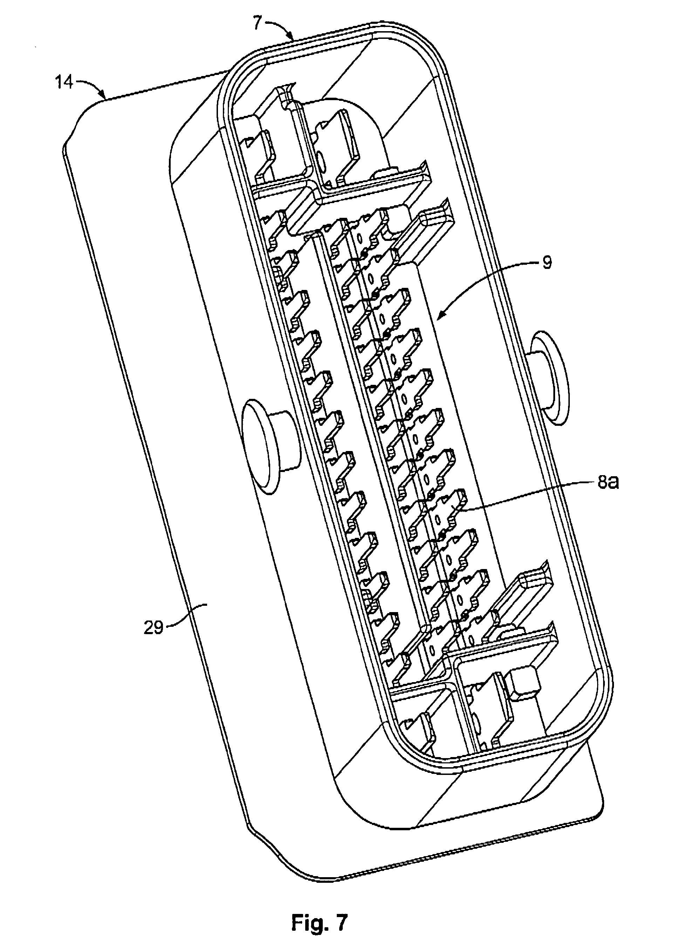

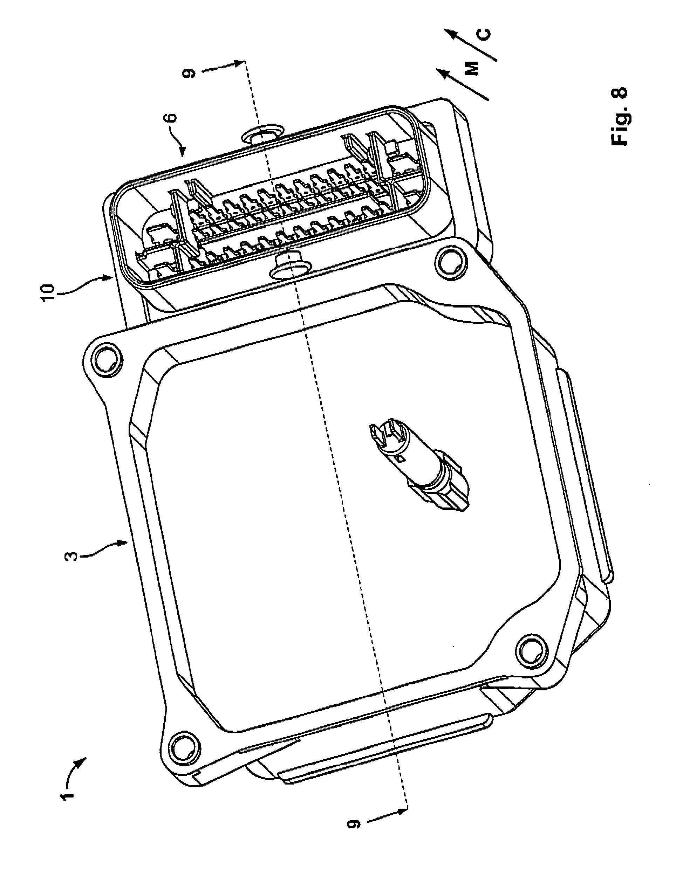

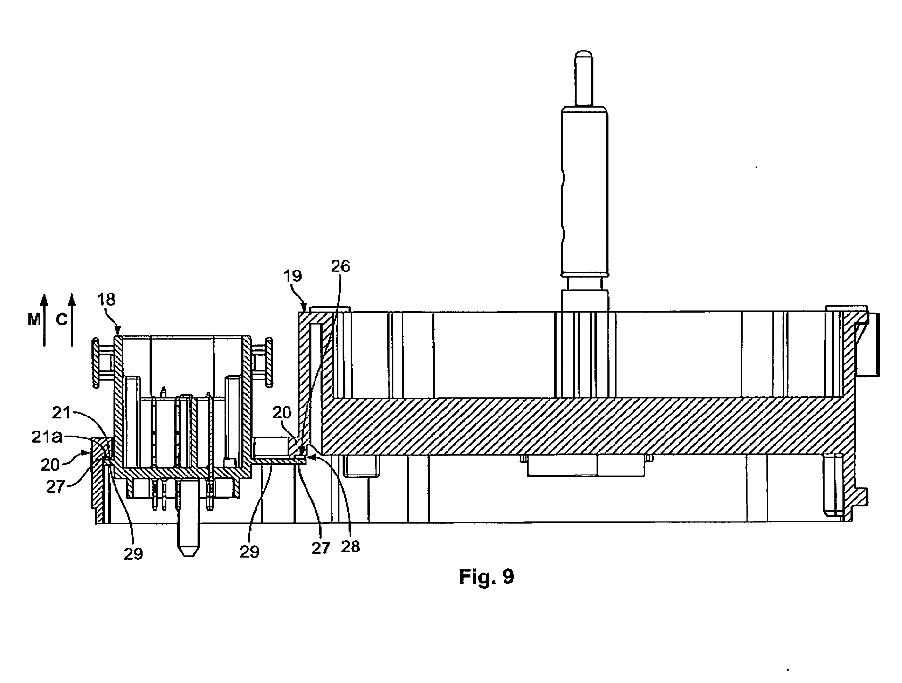

In Figs. 6 to 9, a third embodiment of the inventive braking module 1 is presented. Fig. 6 shows the housing 3 of the braking module 1 according to the third embodiment, Fig. 7 shows the connector 6 of the braking module 1 according to the third embodiment, Fig. 8 shows a schematic perspective view of the braking system 1 according to the third embodiment in the assembled state and Fig. 9 shows a cross-sectional view along the sectional line 9-9 of Fig. 8

In the following, only the differences between the braking module 1 according to the third and the previous embodiments will be described. For elements that are structurally and/or functionally similar or identical to elements of the previous embodiments, the same reference signs will be used.

The housing 3 according to the third embodiment principally corresponds to the housing 6 of the second embodiment having the wide insertion opening 15.

The housing 3 of the third embodiment differs from the housing 6 of the second embodiment only in that the supporting lug 21, which completely circumferences the insertion hole 15, providing the fitting portion area 20, is arranged at the margin 33 of the fitting area 20 that faces in the mounting direction M. Hence, the supporting lug 21 of the attachment frame 11 is arranged at that end of the fitting area 20 surrounding the insertion hole 15, which faces in the mounting direction M, rather than at the opposite end, as it is the case in the housing according to the previous embodiments, shown in Figs. 4 and 5 for example.

The connector 6 of the third embodiment principally, corresponds to the connector 6 of the second embodiment having a flange connection 29 protruding from the outer side walls of the connector body 7 as a connection piece 14. The the flange connection 29 according to the third embodiment is not provided with the pitch 32 of the second embodiment. Rather, the flange connection 29 of the third embodiment is simply designed as a planar collar surrounding the connector body.

Contrary to the braking module 1 according to the first and second embodiments, the connector 6 of the third embodiment is inserted in the mounting direction M into the insertion opening 15 of the anchorage organ 10. Thus, the coupling direction C, in which the connector 6 is mounted with the anchorage organ 10 of the housing 3, principally corresponds to the mounting direction M, in which the braking module 1 is mounted with the cable assembly.

As can be seen in Fig. 9, in the assembled state, the connection flange 29 of the connector 6 abuts against the supporting lug 21 of the attachment frame 11 in the mounting direction M that corresponds to the coupling direction C.

At the junction 28 between the connection flange 29 and the fitting area 20 of the anchorage organ 10, a seam 27 is provided, that forms the joining element 26, fixing the connector 6 with the housing 3, as well as at the same time providing a sealing element 22, by which the junction 28 is made watertight.

### Parts List

| | |
|---|---|
| 1 | braking module |
| 2 | coilbox |
| 3 | Housing |
| 4 | Flange |
| 5 | Bushing hole |
| 6 | Connector |
| 7 | Connector body |
| 8 | Contact element |
| 8a | Contact pin |
| 9, 9a | Connector interface |
| 10 | Anchorage organ |
| 11 | Attachment frame |
| 12 | Side wall of housing |
| 13 | Fitting |
| 14 | Connection piece |
| 15 | Insertion hole |
| 16 | Groove |
| 17 | Coupling face of connection part |
| 18 | (Mounting) face of connector body |
| 19 | (Mounting) face of housing |
| 20 | Fitting area |
| 21 | Supporting lug |
| 21a | Step |
| 22 | Supporting surface |
| 23 | Sealing element |
| 24 | Gasket |
| 25 | Shoulder |
| 26 | Joining element |
| 27 | Glue / seam |
| 28 | Junction |
| 29 | Connection flange |
| 30 | Latch |
| 31 | Potting compound |
| 32 | Pitch |
| 33 | Margin of fitting area facing in M |
| C | Coupling direction |
| M | Mounting direction |

## Claims

1. Braking system module (1), such as an coilbox (2), comprising a housing (3) and a connector (6) with a connector body (7) and contact elements (8) defining a connection interface (9) for electrically connecting the braking module (1) with a plug connector, **characterized in that** the housing (3) comprises an anchorage organ (10) for mounting the connector (6) to the housing (3).

2. Braking module (1) according to claim 1, wherein the connector (6) is mounted and optionally fixed at the anchorage organ (10) of the housing (3).

3. Braking module (1) according to claim 1 or 2, wherein the anchorage organ (10) comprises a fitting (13) that is adapted for coupling with a connection piece (14) of the connector body (7).

4. Braking module (1) according to any one of claims 1 to 3, comprising a joining element (26) for fixing the mounted connector body (7) with the anchorage organ (10).

5. Braking module (1) according to claim 4, wherein the joining element (26) is selected from at least one of a seam (27), a glue, and a fastener.

6. Braking module (1) according to claim 5, wherein the joining element (26) is a snap fit (29, 30).

7. Braking module (1) according to any one of claims 4 to 6, wherein the joining element (26) is arranged at the anchorage organ (10) and/or the connection piece (14).

8. Braking module (1) according to claim 7, wherein the anchorage organ (10) comprises a latch (30) forming a snap fit (29, 30) with the corresponding counter latch (29) of the connector body (7).

9. Braking module (1) according to any one of claims 1 to 8, comprising a sealing element (23) for sealing a junction (28) between the anchorage organ (10) and the connector body (7) mounted thereto.

10. Braking module (1) according to claim 9, wherein the sealing element (23) is selected from a washer, grommet, gasket (24), a seam (27) and a potting compound (31).

11. Braking module (1) according to claim 9 or 10, wherein a sealing element (23) is placed at the junction (28) between the anchorage organ (10) and the connector body (7).
